# EUROPEAN PATENT SPECIFICATION

(11) **EP 0 525 869 B1**
(45) Date of publication and mention of the grant of the patent: **24.06.1998**
(21) Application number: 92202198.5
(22) Date of filing: 17.07.1992
(51) Int. Cl.: H03K 17/06, H03K 17/687, H03K 19/017

(54) **Bootstrap circuit for driving a power MOS transistor in pull-up mode**
Bootstrapschaltung zum Treiben von einem Leistungs-MOS-Transistor in einem Erhöhungsmode
Circuit du type bootstrap pour attaquer un transisteur MOS de puissance dans un mode de tirage

(30) Priority: 24.07.1991 IT MI912045
(43) Date of publication of application: 03.02.1993
(73) Proprietor: Consorzio per la Ricerca sulla Microelettronica nel Mezzogiorno - CoRiMMe, 95100 Catania (IT); SGS-THOMSON MICROELECTRONICS s.r.l., 20041 Agrate Brianza (Milano) (IT)
(72) Inventor: Zisa, Michele, I-97013 Comiso (Ragusa) (IT); Belluso, Massimiliano, I-95040 Catania (IT); Paparo, Mario, I-95037 San Giovanni La Punta (Catania) (IT)
(74) Representative: Mittler, Enrico

(56) References cited:
- EP-A- 0 126 788
- US-A- 4 049 979

## Description

The present invention is concerned with a bootstrap circuit for driving a power MOS transistor in high side driver configuration.

The operation at low supply voltage of discrete devices, as well as of integrated circuits, working at high frequencies, which make use of a power MOS transistor in the so called "high side driver" configuration, is limited, in the classic driving configurations, by the threshold voltage of the power MOS transistor, that is by the minimum voltage which has to be applied between the gate and the source of the power MOS transistor itself so that current can start flowing between the drain and the source.

A classic technology, for istance, realizes power MOS devices with a threshold voltage of about 3.5 volts. It follows that in order to obtain a reliable operation, as a switch, of the power MOS transistor itself it is necessary to apply between its gate and its source a voltage at least twice as much the threshold voltage, in the specific case therefore higher than 7 volts.

Since a bootstrap circuit realized in the classic way allows the application, between gate and source of the power MOS transistor, of a voltage equal to the supply voltage less the losses introduced by the circuit itself, it follows that, in order to achieve a reliable operation of the power MOS transistor, the minimum value of the supply voltage to the circuit has necessarily to be higher than 7 volts.

Two classic circuit configurations are known for the drive of a power MOS transistor:
- the bootstrap, which operates at a frequency equal to the switching frequency of the power MOS transistor,
- the charge-pumping circuit, which operates at a frequency much higher than that of the power MOS transistor.

Examples of these circuits are described in the article " Drive Techniques for High Side N-Channel MOSFET's " by Warren Schultz, Motorola Inc. SPS, included in the magazine PCIM of June 1987.

US-A-4 049 979 discloses a bootstrap driver circuit for a power MOS transistor in high side driver configuration as defined in the preamble of the independent claims 1 and 2.

Object of the present invention is to realize a bootstrap circuit for the drive of a power MOS transistor in the high side configuration that is capable of operating at low levels of supply voltage when the power MOS transistor is to operate at high switching frequencies.

According to the invention such an object is achieved with a bootstrap circuit fo a power MOS transistor in the high side configuration, as defined in the independent claims 1 and 2.

The features of the present invention will be made more evident by embodiments thereof shown by way of examples in the enclosed drawings where:
Figure 1 shows a first embodiment of the circuit according to the invention;
Figure 2 shows a second embodiment of the circuit according to the invention;
Figure 3 shows the signal patterns on the gate and the source of the power MOS transistor and across the second capacitor in the first embodiment of the bootstrap circuit according to the invention;
Figure 4 shows the same patterns as Figure 3 in a classic bootstrap circuit;
Figure 5 shows the comparison between the signal patterns on the gate and the source of the power MOS transistor in the circuits of Figure 1 and 2.

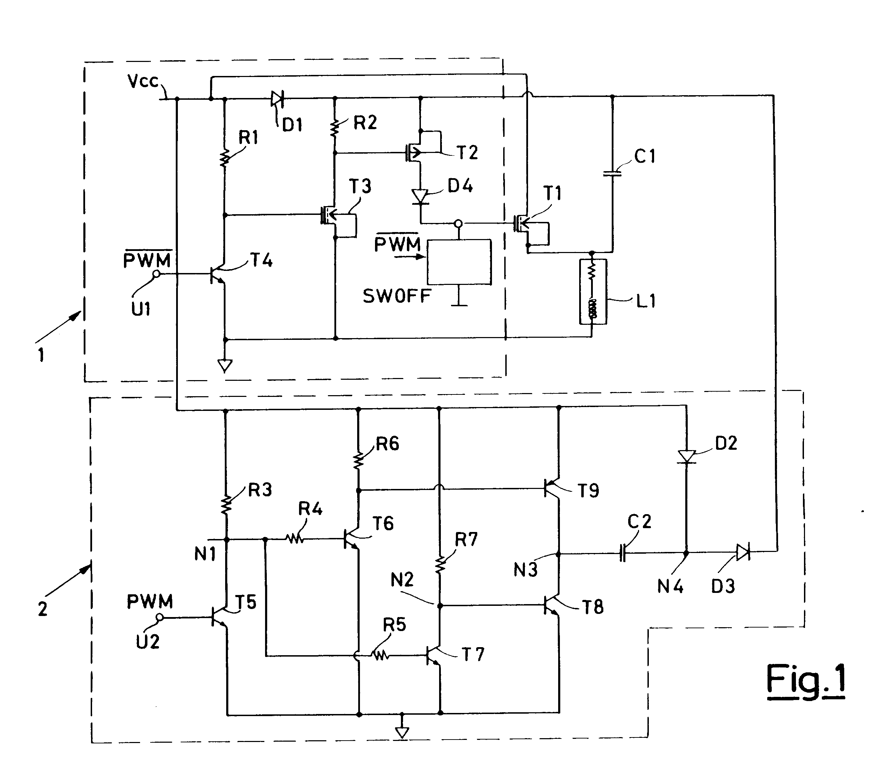

With reference to Figure 1, according to a first embodiment the bootstrap circuit is composed by two blocks, represented by dashed lines and identified by the reference numbers 1 and 2.

The block 1 represents a classic circuit for a power, n-channel MOS transistor T1. It includes a bipolar npn transistor T4 with the base connected to an input U1 for an inverted PWM signal, emitter connected to ground, collector connected on one side to a resistor R1 connected in turn to a supply voltage Vcc, on the other side to the gate of an n-channel MOS transistor T3. The source of the transistor T3 is grounded and the drain is connected on one side to a resistor R2, on the other side to the gate of a p-channel MOS transistor T2. The R2 resistor is in turn connected to the supply Vcc through a diode D1 interposed between the resistors R1 and R2.

The source of the transistor T2 is connected through the diode D1 to the supply Vcc. The drain of the transistor T2 is connected through a diode D4 to the gate of the power MOS transistor T1. To the gate of the power transistor T1 there is also connected a switch-off circuit SWOFF for the power transistor T1, which connects the above-said gate to ground when the inverted PWM signal rises to high level.

The block 2 includes an npn-type bipolar transistor T5 with the base connected to an input U2 for a PWM switch-on signal, emitter connected to ground, collector connected to the supply Vcc through a resistor R3. At a circuit node N1 situated between the collector of the transistor T5 and the resistor R3 there is connected a resistor R4 connected in turn to the base of an npn-type bipolar transistor T6. The emitter of the transistor T6 is at ground, while the collector is connected on one side to the supply Vcc through a resistor R6, on the other side to the base of an npn-type bipolar transistor T9. The emitter of the T9 transistor is connected to the supply Vcc, while the collector is connected to an npn-type transistor T8. The emitter of the T8 transistor is at ground and the base is connected to an intermediate node N2 between a resistor R7 and the collector of an npn-type bipolar transistor T7. The emitter of the transistor T7 is at ground, while the base is connected through a resistor R5 to the node N1.

To an intermediate circuit node N3 between the collectors of transistors T8 and T9 there is connected a capacitor C2. At the other side the capacitor C2 is connected at a circuit node N4 to a diode D2 connected in turn to the supply Vcc.

The capacitor C2 is also connected through a diode D3 to one side of the capacitor C1, which is external to the bootstrap circuit, and then to the supply Vcc.

On the other side the capacitor C1 is connected to the source of the transistor T1 and through a resistive/inductive load L1 to ground.

With reference to the block 1, the bootstrap is operated through an inverted PWM signal obtained from the PWM signal which operates the block 2. This signal is also in opposition, logicwise, to the voltage value present on the load L1 of the power MOS transistor T1, in the sense that to a high value of the voltage present on the load L1, that is with the MOS power transistor T1 in conduction, there corresponds a low value of the inverted PWM signal at the input U1.

Let us suppose that the inverted PWM signal present on the base of the transistor T4 is low. In this condition the transistor T4 is turned off.

The gate of the n-channel MOS transistor T3 is connected through the resistor R1 to the supply voltage Vcc, therefore the transistor T3 is turned on causing the gate of the p-channel MOS transistor T2 to go low.

The MOS transistor T2 is then turned on and in this condition it is capable to transfer the charge of the capacitor C1, through the transistor T2 itself and the diode D4, to the gate of the power MOS transistor T1, which is thus turned on.

During this phase the diode D1 is reverse-biased as there are present:
at the anode the supply voltage Vcc
at the cathode a voltage which is the sum of the voltage Vcc - Vdson (Vdson = drain-source voltage when the transistor is conducting) present at the source of the power MOS transistor T1 at the instant of the turn on and of the voltage Vcc present across the capacitor C1 and transferred to the gate of the power MOS transistor T1,
and it decouples the voltage present across the capacitor C1 from the supply voltage Vcc.

With reference to the block 2, still in the case where the inverted PWM signal at the input of the block 1 is low, the corresponding PWM signal at the input U2 of the block 2 is high.

The transistor T5 is turned on and consequently, since the collector of the transistor T5 goes low, the transistors T6 and T7 are turned off.

The signal at the collector of the transistor T6 is high, so that the pnp-type transistor T9, whose base is driven by the collector of the transistor T6, is turned off. On the contrary, since the transistor T7 is turned off, the transistor T8 is turned on, being its base connected to the supply voltage Vcc through the resistor R7.

Under these conditions the capacitor C2 charges up to the voltage Vcc - Vbe(D2), when considering negligible the saturation voltage of the transistor T8.

Coming back to the block 1, let us suppose that the inverted PWM signal at the input U1 switches from low to high; the transistor T4 goes into conduction turning off the transistor T3 directly and the transistor T2 indirectly through T3. As a consequence the capacitor C1 is disconnected from the gate of the power MOS transistor T1, which gate is brought to ground by the switch-off circuit SWOFF.

At the same time, as far as the block 2 is concerned, the corresponding PWM signal at the gate of the transistor T5 switches from high to low. Under this condition the transistor T5 is turned off, while the transistors T6, T7 are turned on because their bases are connected to the supply voltage Vcc respectively through the series of the resistors R4 + R3 and R5 + R3.

The signal at the collector of the transistor T6 is low, so that the transistor T9, whose base is driven by the collector of the transistor T6, is turned on. On the contrary, since the transistor T7 is turned on, the transistor T8 is turned off because its base is low.

Under these conditions the terminal of the capacitor C2 connected to the collector of the transistor T9 goes, apart from Vcesat(T9), to the supply voltage Vcc and therefore the other terminal, which was already charged to the voltage Vcc - Vbe(D2), is charged to the voltage:$\text{Vcc + Vcc - Vbe(D2)}$

Assuming, in the specific case, C2 much greater than C1, the capacitor C1 then charges up through the diode D3 to a voltage approximately equal to:$\text{2Vcc - Vbe(D2) -Vbe(D3)}$ so, when the PWM and inverted PWM signals switch back to high and, respectively, low level, the capacitor C1 applies between gate and source of the power MOS transistor T1 a voltage Vgs equal to:$\text{2Vcc - Vbe(D2) -Vbe(D3) -Vbe(D4)}$ and therefore capable to trigger the switch back of the power transistor even in case of low supply voltage Vcc.

In the case where the bootstrap circuit would have been composed only by the block 1, as it occurs in the known techniques, during the time interval where the inverted PWM signal is high the capacitor C1 would have charged through the diode D1 to a voltage Vcc - Vbe(D1). During the switch-back of the inverted PWM signal from high to low this charge would then have been transferred back to the base of the transistor T1. This one would then have been turned on with a voltage Vgs equal to Vcc - Vbe(D1) - Vbe(D4), which would have therefore resulted much lower than the switch on voltage utilized with the bootstrap circuit in compliance with the invention and not capable to provide for the switch back of the power transistor in case of low voltage of the supply Vcc.

With the circuit of Figure 1 it is on the contrary possible to obtain, if C2 is much greater than C1, an increment of the voltage necessary to bring the transistor T1 into conduction.

Of course the efficiency of the circuit decreases with the ratio of the values of the capacitors C2/C1, as the voltage across C1 decreases with it.

A peculiarity of this first embodiment of the bootstrap circuit is that the charge of the capacitor C2 takes place in phase with the switch on of the power MOS transistor T1.

In this circuit moreover the diodes D2 and D3 serve for decoupling the capacitor C2, respectively, from the supply voltage Vcc and from the capacitor C1, in the moment when the capacitor C1 transfers its charge to the gate of the power MOS transistor T1.

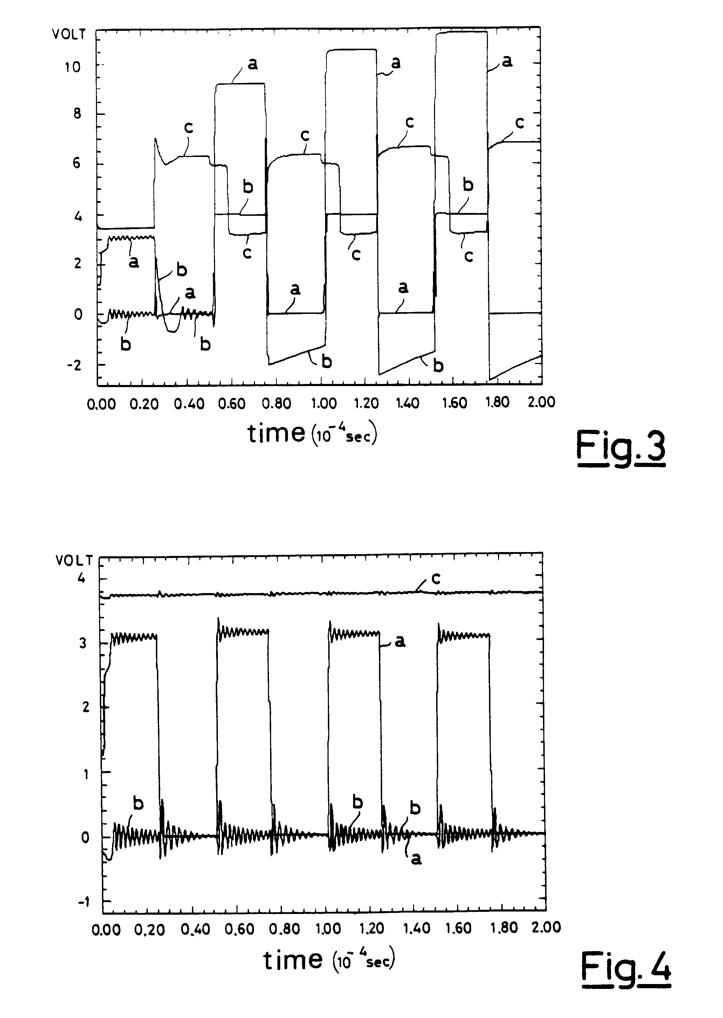

In Figures 3 and 4 the curves a, b, c, show the patterns with time of the voltage at the gate of transistor T1, at the source of transistor T1 and at the terminals of the capacitor C2 at the circuit node N3, respectively in a bootstrap circuit in compliance with the invention and in one of the classic type without the block 2, with a voltage Vcc equal to 4 volts.

A comparison between the two figures allows to realize the effect of the presence of block 2 which results, as described above, in an increment of the gate-source voltage for the turn on of the power MOS transistor T1.

According to this first embodiment of the bootstrap circuit in compliance with the invention the capacitor C1 is therefore charged with a capacitor C2 placed in parallel to it.

As an alternative the bootstrap circuit, according to a second embodiment, can be realized in a way as to charge the capacitor C1 and a capacitor C2 connected in series.

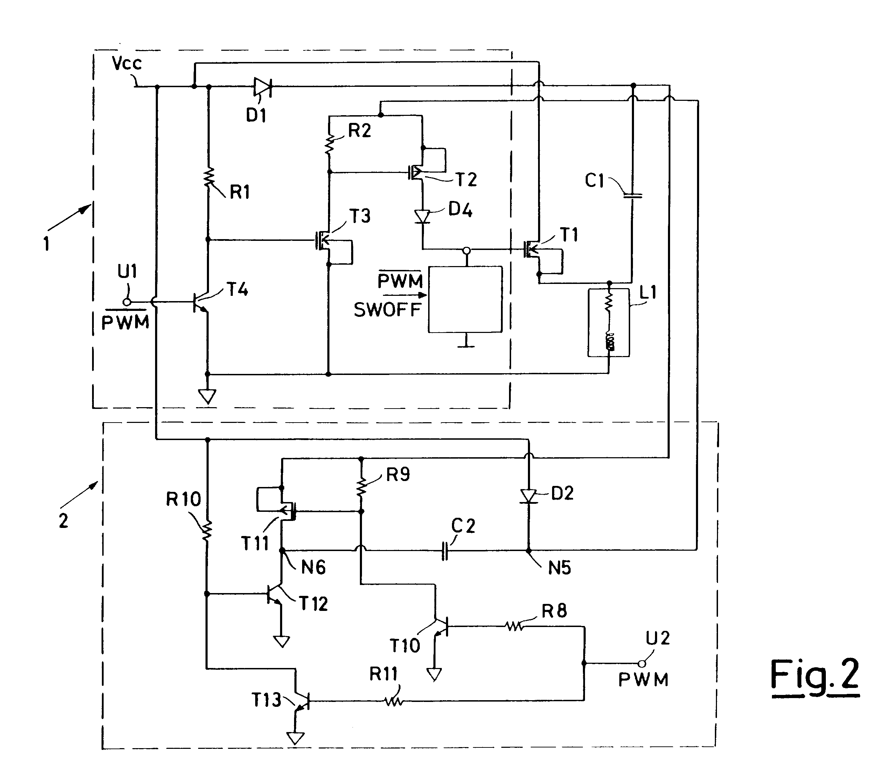

The bootstrap circuit in its second embodiment shown in Figure 2 differs from that shown in Figure 1 as far as the realization of the block 2 and the absence of the diode D3 are concerned. The block 2 in particular includes an npn-type bipolar transistor T10 with the base connected through a resistor R8 to the input U2 of the PWM signal, emitter connected to ground, collector connected to the gate of a p-channel MOS transistor T11 and to a resistor R9. The resistor R9 is in turn connected at one side to the source of the transistor T11, at the other side to the supply voltage Vcc.

The drain of the transistor T11 is connected at a circuit node N6 at one side to the capacitor C2, at the other side to the collector of an npn-type bipolar transistor T12. The capacitor C2 is in turn connected at a circuit node N5 to a diode D2 which at the other end is connected to the supply Vcc. The emitter of the bipolar transistor T12 is grounded and the base is connected at one side through a resistor R10 to the supply Vcc, at the other side to the collector of an npn-type bipolar transistor T13.

The emitter of the transistor T13 is grounded and the base is connected through a resistor R11 to the input U2 of the PWM signal.

As to its operation the circuit of Figure 2 works as follows.

In the case where the PWM signal present at the input U2 of the block 2 is low (in this phase, as already shown before with reference to the operation of the circuit shown in Figure 1, the MOS transistor T1 is turned off) the transistors T10 and T13 are turned off because their base is low.

The transistor T12 is turned on because its base is connected to the supply through the resistor R10.

The capacitor C2 charges up to the value:$\text{Vcc - Vbe(D2) - Vcesat(T12)}$

The capacitor C1 instead charges up to the value:$\text{Vcc - Vbe(D1)}$

When the PWM signal at the input U2 of the block 2 goes high, the transistors T10 and T13 are turned on. In this case the transistor T12, whose base is brought low because connected to the collector of the transistor T13, turns off, while the p-channel MOS transistor T11, driven on the gate by the collector of the transistor T10, turns on.

In such a way the two capacitors C1 and C2 result connected in series through T11 and altogether charge up to the voltage:$\text{2Vcc - Vbe(D1) - Vbe(D2) - Vcesat(T12)}$

In this case the classic bootstrap circuit represented by the block 1 connects the two capacitors C1 and C2 in series to the gate of the power MOS transistor T1 turning it on at a voltage:$\text{Vgson = ( (2Vcc-Vbe(D1)-Vbe(D2)-Vcesat(T12) )-Vbe(D4)}$

Unlike the circuit in compliance with the first embodiment, in this circuit the charge of the capacitor C2 takes place in opposition of phase with the switching on of the power MOS transistor T1.

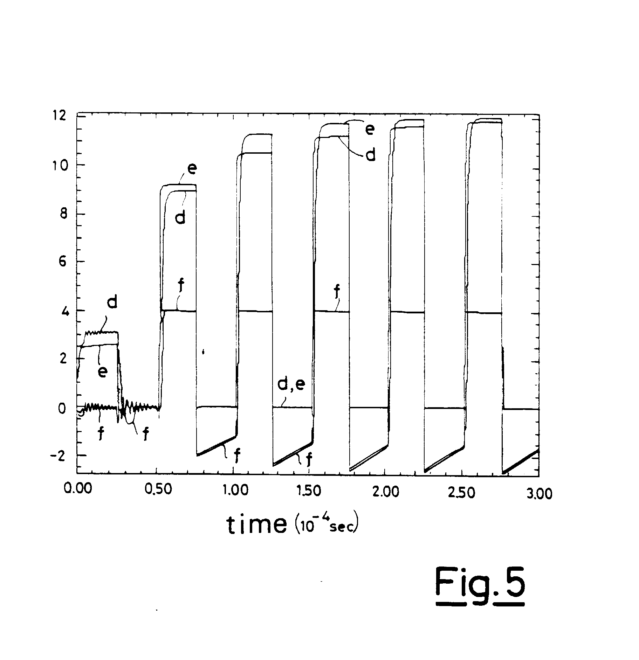

In Figure 5 there are shown the patterns as a function of time of the different gate voltages of the bootstrap circuits according to the first embodiment, curve d, and according the second embodiment, curve e, as well as the pattern, the same in the two cases, of the source voltage of the power transistor T1, curve f.

It is possible to notice the increment of the gate voltage obtained by means of the use of the bootstrap circuit according the second embodiment, that is with the connection in series of the two capacitors C1 and C2.

In general the bootstrap circuit both in its embodiment of Figure 1 and in its variant of Figure 2 improves the efficiency of a classic bootstrap circuit for the drive of a power MOS transistor in the high side driver configuration allowing the operation of the device, which includes the bootstrap circuit and the power MOS transistor, at values of supply voltage lower than about 7 volts, when the MOS transistor is to operate at high frequencies, as for example in the switching phase.

The block 2 can also be realized, totally or partially, with MOS devices.

In addition the circuits shown in Figure 1 and 2 can be totally integrated in bipolar, MOS, mixed (bipolar, CMOS, DMOS) technology, or can be realized with discrete components.

## Claims

1. Bootstrap circuit for a power MOS transistor in high side driver configuration, comprising a first capacitor (C1) chargeable to a first voltage which is somewhat less than the supply voltage (Vcc) of the power transistor (T1) and a second capacitor (C2), said circuit making available a second voltage higher than said supply voltage and the threshold voltage of the power MOS transistor (T1) at the gate thereof, characterized in that said first capacitor (C1) has a first terminal connected to the load (L1) and a second terminal connected to said supply voltage (Vcc) through a first diode (D1) and to the gate of the power MOS transistor (T1) through first switching means (T2) controlled by an activating signal (PWM), and said second capacitor (C2) has a first terminal connected to the said supply voltage through a second diode (D2) and connected to the second terminal of said first capacitor (C1) through a third diode (D3) and a second terminal connected to ground through second switching means (T8)

2. Bootstrap circuit for a power MOS transistor in high side driver configuration, comprising a first capacitor (C1) chargeable to a first voltage which is somewhat less than the supply voltage (Vcc) of the power transistor (T1) and a second capacitor (C2), said circuit making available a second voltage higher than said supply voltage and the threshold voltage of the power MOS transistor (T1) at the gate thereof, said first capacitor (C1) has a first terminal connected to the load (L1) and a second terminal connected to said supply voltage (Vcc) through a first diode (D1) and by switching means (T3, T2, D4) interposed between a first terminal of said second capacitor (C2) and the gate of the power MOS transistor (T1), and said second capacitor (C2) has a first terminal connected to the said supply voltage through a second diode (D2) and in that a second terminal of characterized in that to the second terminal of said second capacitor (C2) is connected said first capacitor (C1) through a transistor (T11) and said second voltage is taken across said capacitors (C1, C2).

## Patentansprüche

1. Bootstrapschaltung für einen Leistungs-MOS-Transistor in Hochseitentreiberanordnung, mit:
einem ersten Kondensator (C1), der auf eine erste Spannung aufladbar ist, die etwas geringer als die Versorgungsspannung (Vcc) des Leistungstransistors (T1) ist, und einem zweiten Kondensator (C2),
wobei die Schaltung eine zweite Spannung höher als die Versorgungsspannung und die Schwellenspannung des Leistungs-MOS-Transistors (T1) an seinem Gate bereitstellt,
dadurch gekennzeichnet,
daß der erste Kondensator (C1) einen mit der Last (L1) verbundenen ersten Anschluß und einen zweiten Anschluß aufweist, der mit der Versorgungsspannung (Vcc) durch eine erste Diode (T1) und mit dem Gate des Leistungs-MOS-Transistors (T1) durch ein durch ein Aktivierungssignal (PWM) gesteuertes erstes Schaltmittel (T2) verbunden ist, und
daß der zweite Kondensator (C2) einen mit der Versorgungsspannung durch eine zweite Diode (D2) verbundenen ersten Anschluß, der mit dem zweiten Anschluß des ersten Kondensators (C1) durch eine dritte Diode (D3) verbunden ist, und einen mit Masse durch ein zweites Schaltmittel (T8) verbundenen zweiten Anschluß aufweist.

2. Bootstrapschaltung für einen Leistungs-MOS-Transistor in Hochseitentreiberanordnung, mit:
einem ersten Transistor (C1), der auf eine erste Spannung aufladbar ist, die etwas geringer als die Versorgungsspannung (Vcc) des Leistungstransistors (T1) ist, und
einem zweiten Kondensator (C2),
wobei die Schaltung eine zweite Spannung höher als die Versorgungsspannung und die Schwellenspannung des Leistungs-MOS-Transistors (T1) an seinem Gate bereitstellt,
dadurch gekennzeichnet,
daß der erste Kondensator (C1) einen mit der Last (L1) verbundenen ersten Anschluß und einen zweiten Anschluß aufweist, der mit der Versorgungsspannung (Vcc) durch eine erste Diode (D1) und durch Schaltmittel (T3, T2, T4) verbunden ist, das zwischen einen ersten Anschluß des zweiten Kondensators (C2) und das Gate des Leistungs-MOS-Transistors (T1) eingefügt ist,
daß der zweite Kondensator einen mit der Versorgungsspannung durch eine zweite Diode (D2) verbundenen ersten Anschluß aufweist und
daß der zweite Kondensator (C2) mit dem zweiten Anschluß des ersten Kondensators (C1) durch einen Transistor (T11) verbunden ist und
daß die zweite Spannung über die Kondensatoren (C1, C2) genommen wird.

## Revendications

1. Circuit autoélévateur pour un transistor MOS de puissance en configuration de circuit d'attaque côté haut, comprenant un premier condensateur (C1) pouvant être chargé à une première tension qui est quelque peu inférieure à la tension d'alimentation électrique (Vcc) du transistor de puissance (T1) et un deuxième condensateur (C2), ledit circuit rendant disponible une deuxième tension plus élevée que ladite tension d'alimentation et la tension de seuil du transistor MOS de puissance (T1) au niveau de la grille de celui-ci, caractérisé en ce que ledit premier condensateur (C1) possède une première borne connectée à la charge (L1) et une deuxième borne connectée ladite tension d'alimentation (Vcc) par l'intermédiaire d'une première diode (Dl) et à la grille du transistor MOS de puissance (T1) par l'intermédiaire d'un premier moyen de commutation (T2) commandé par un signal d'activation (PWM), et ledit deuxième condensateur (C2) possède une première borne connectée à ladite tension d'alimentation par l'intermédiaire d'une deuxième diode (D2) et connectée à la deuxième borne dudit premier condensateur (C1) par l'intermédiaire d'une troisième diode (D3) et une deuxième borne connectée à la terre par l'intermédiaire d'un deuxième moyen de commutation (T8).

2. Circuit autoélévateur pour un transistor MOS de puissance en configuration de circuit d'attaque côté haut, comprenant un premier condensateur (C1) pouvant être chargé une première tension qui est quelque peu inférieure à la tension d'alimentation électrique (Vcc) du transistor de puissance (Tl) et un deuxième condensateur (C2), ledit circuit rendant disponible une deuxième tension plus élevée que ladite tension d'alimentation et la tension de seuil du transistor MOS de puissance (T1) au niveau de la grille de celui-ci, caractérisé en ce que ledit premier condensateur (C1) possède une première borne connectée la charge (L1) et une deuxième borne connectée à ladite tension d'alimentation électrique (Vcc) par l'intermédiaire d'une première diode (Dl) et par un moyen de commutation (T3, T2, D4) s'interposant entre une première borne dudit deuxième condensateur (C2) et la grille du transistor de puissance MOS (T1) et ledit deuxième condensateur (C2) possède une première borne connectée à ladite tension d'alimentation électrique par l'intermédiaire d'une deuxième diode (D2) et en ce qu'une deuxième borne dudit deuxième condensateur (C2) est connectée à la deuxième borne dudit premier condensateur (C1) par l'intermédiaire d'un transistor (T11) et ladite deuxième tension est prise sur lesdits condensateurs (C1, C2).
